# FASCICULE DE BREVET EUROPEEN

(11) **EP 2 057 687 B1**
(45) Date de publication et mention de la délivrance du brevet: **22.04.2015**
(21) Numéro de dépôt: 07803768.6
(22) Date de dépôt: 21.06.2007
(51) Int. Cl.: G06K 19/077, H01L 29/06, H01L 25/065, H01L 21/98, A41D 1/00, H01L 23/48, G06K 19/02, H01Q 1/22, H01Q 7/00, H01L 23/58, H01L 23/49

(54) **PUCE MICROELECTRONIQUE NUE MUNIE D'UNE RAINURE FORMANT UN LOGEMENT POUR UN ELEMENT FILAIRE CONSTITUANT UN SUPPORT MECANIQUE SOUPLE, PROCEDE DE FABRICATION ET MICROSTRUCTURE**
UNGEHÄUSTER MIKROELEKTRONISCHER CHIP, DER MIT EINER AUSHÖHLUNG AUSGESTATTET IST, DIE EIN GEHÄUSE FÜR EIN DRAHTELEMENT BILDET, DAS EINE FLEXIBLE MECHANISCHE STRUKTUR DARSTELLT, HERSTELLUNGSPROZESS UND MIKROSTRUKTUR
BARE MICROELECTRONIC CHIP PROVIDED WITH A RECESS FORMING A HOUSING FOR A WIRE ELEMENT CONSTITUTING A FLEXIBLE MECHANICAL SUPPORT, FABRICATION PROCESS AND MICROSTRUCTURE

(30) Priorité: 29.08.2006 FR 0607588
(43) Date de publication de la demande: 13.05.2009
(73) Titulaire: Commissariat à l'Énergie Atomique et aux Énergies Alternatives, 75015 Paris (FR)
(72) Inventeur: VICARD, Dominique, 38330 Saint Nazaire les Eymes (FR); MOUREY, Bruno, 38500 Coublevie (FR); BRUN, Jean, 38800 Champagnier (FR)
(74) Mandataire: Hecké, Gérard
(86) Numéro de dépôt international: PCT/FR2007/001034
(87) Numéro de publication internationale: WO 2008/025889

(56) Documents cités:
- JP-A- 2003 086 762
- JP-A- 2003 163 313
- US-A1- 2003 082 851
- US-A1- 2003 211 797
- US-A1- 2005 223 552
- US-A1- 2005 277 307
- US-A1- 2006 175 697
- US-B1- 6 646 336

## Description

### Domaine technique de l'invention

L'invention est relative à une puce microélectronique comportant deux faces principales parallèles et des faces latérales.

L'invention porte également sur un procédé de fabrication d'une telle puce microélectronique et sur une microstructure comportant au moins deux puces connectées par un élément filaire.

### État de la technique

Actuellement, de nombreuses applications réclament la confection de tissus ou de tricots apportant des fonctions électroniques, appelés textiles actifs. Par exemple les tissus thermoélectriques génèrent de l'énergie à partir d'un gradient de température, les tissus piézoélectriques sont capables d'alimenter une électronique par récupération d'énergie de mouvement. Cette énergie alimente alors un circuit électronique solidaire du tissu.

Deux techniques de fabrication de tels textiles sont actuellement pratiquées. Dans l'une d'elles, les fonctions électroniques sont obtenues par adjonction de circuits électroniques aux textiles. Par exemple, les fonctions électroniques sont réalisées par une puce microélectronique classiquement reliée à d'autres puces ou à une alimentation en énergie par l'intermédiaire de plots reliés à des éléments mécaniques soudables au moyen de fils de liaison, un boîtier protégeant le circuit et les plots. Les fonctions électroniques réalisables peuvent être complexes, mais la stabilité mécanique de la puce électronique intégrée dans le textile est très mauvaise. Une telle intégration est longue et nécessite des machines spéciales complexes. D'autre part, la connectique présente un encombrement non négligeable devant celui de la partie active de la puce.

Dans l'autre technique de fabrication, encore expérimentale, l'électronique est imprimée sur le textile, ce dernier jouant le rôle de support. Généralement ces textiles supports sont obtenus par tissage classique. Mais la complexité des fonctions électroniques réalisables par ces techniques est très limitée et bien inférieure à celle que l'on peut atteindre avec des puces microélectroniques.

Le document US 2005/223552 A1 décrit un dispositif comprenant un substrat et un circuit séparés par une entretoise de façon à définir des rainures délimitées chacune par une des faces principales du circuit, une des faces latérales de l'entretoise et une des faces principales du substrat. Des plots de contact électrique se trouvent sur les parois latérales des rainures, et sont connectés à des éléments filaires dont une extrémité est logée à l'intérieur des rainures. Les éléments filaires sont sensiblement perpendiculaires aux axes des rainures.

### Objet de l'Invention

L'objet de l'invention consiste à réaliser une puce microélectronique dont l'intégration dans un tissu ou un tricot est améliorée.

Selon l'invention, ce but est atteint par les revendications annexées et notamment par une puce microélectronique selon la revendication 1.

L'invention a également pour objet un procédé de fabrication, selon la revendication 10, d'une puce microélectronique dans laquelle l'évidement est constitué par une rainure située sur au moins une face latérale.

Un développement concerne également une microstructure comportant au moins deux puces microélectroniques selon l'une des revendications 1 à 9.

### Description sommaire des dessine

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- la figure 1 est une vue en coupe d'un premier exemple de réalisation d'une puce microélectronique selon l'invention,
- la figure 2 est une vue en coupe d'un deuxième exemple de réalisation d'une puce microélectronique selon l'invention,
- les figures 3 à 5 illustrent les différentes étapes d'un procédé de fabrication de la puce selon la figure 2,
- la figure 6 représente une vue en coupe d'une variante de réalisation d'une puce selon la figure 2,
- les figures 7 et 8 illustrent deux autres modes de réalisation d'une puce selon l'invention,
- les figures 9 et 10 illustrent un procédé de réalisation d'un autre mode de réalisation d'une puce selon l'invention,
- les figures 11 à 13 illustrent un autre procédé de réalisation d'une puce selon l'invention,
- les figures 14 à 17 illustrent une puce, dans lequel l'élément filaire est perpendiculaire aux faces principales de la puce.

### Description de modes préférentiels de l'Invention

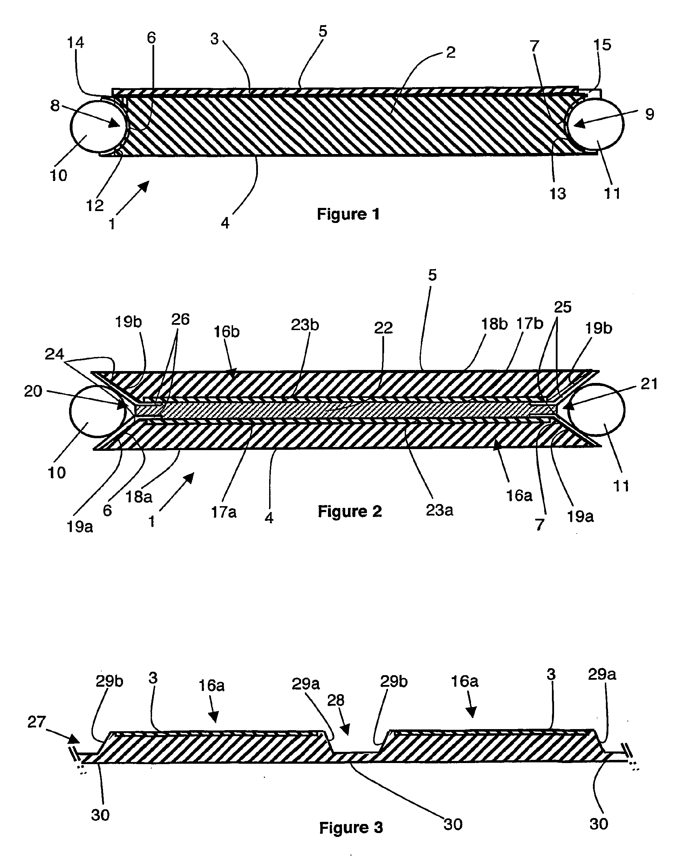

Sur la figure 1, un premier exemple de puce microélectronique 1 comporte un substrat 2 plan muni, de manière classique, d'au moins un composant microélectronique 3. La puce microélectronique 1 possède ainsi deux faces principales 4 et 5 parallèles entre elles, reliées par des faces latérales constituant la tranche de la puce 1. Seules deux faces latérales 6, 7 sont représentées, mais leur nombre peut varier et dépend de la forme du contour des faces principales 4, 5.

Comme l'illustre la figure 1, chaque face latérale 6, 7 est en forme de gouttière parallèle aux faces principales 4 et 5 et constitue une rainure, repérée respectivement 8 et 9 pour les faces latérales 6, 7 et permettant de loger un élément filaire. Les rainures de logement 8, 9 présentent chacune une section concave. Dans le mode de réalisation particulier illustré à la figure 1, la largeur des rainures 8, 9 est égale à la hauteur des faces latérales 6, 7 et sa section est en arc de cercle, c'est-à-dire en forme de C. La forme en C peut être exacte ou approximée avec des segments de droites.

Les rainures 8 et 9 peuvent être réalisées par toute technique adaptée, comme par exemple par gravure sèche ou humide, ablation laser, gravure chimique assistée par laser, usinage mécanique...

La puce microélectronique 1 peut ainsi être facilement intégrée dans un textile car deux fils 10 ,11 adjacents, par exemple de trame, constitutifs de ce textile peuvent venir automatiquement s'insérer dans les rainures de logement 8, 9, que ce soit avec un procédé de tissage ou un procédé de tricotage. Les rainures de logement 8, 9 assurent une stabilité mécanique de la puce microélectronique 1 par rapport au textile. Il est clair qu'on tentera d'adapter le rayon de courbure des rainures de logement 8, 9 au diamètre des fils 10, 11. Des rainures analogues peuvent être envisagées pour les fils de chaîne.

En variante, les rainures 8, 9 peuvent être revêtues par une couche électriquement conductrice, respectivement 12, 13. Cette disposition permet d'utiliser des fils 10, 11 de trame ou de chaîne qui sont conducteurs électriquement et d'assurer un contact électrique avec ces fils 10, 11. Les fils peuvent alors être utilisés pour l'alimentation électrique du composant microélectronique 3 et, éventuellement, pour le transfert de données avec un multiplexage alimentation/données. Les fils peuvent aussi constituer des éléments rayonnants d'antenne (émission ou réception). Les couches électriquement conductrices 12, 13 peuvent être reliées électriquement, de manière classique, au composant microélectronique 3 par l'intermédiaire d'un via traversant 14 perpendiculaire aux faces principales 4, 5 ou d'une piste conductrice 15 déposée sur la face du substrat 2 munie du composant 3 pour raccorder la couche 13 à un contact du composant 3.

Dans une variante, les rainures de logement 8, 9 peuvent avoir une section en forme de V ou de V tronqué. Dans ce dernier cas, chaque rainure 8, 9 comporte deux parois convergentes reliées entre elles par un fond plan.

Dans l'exemple de réalisation, illustré à la figure 2, la puce microélectronique 1 est constituée de deux puces élémentaires 16a et 16b, de section sensiblement trapézoïdale, comprenant chacune une petite base, 17a ou 17b et une grande base, 18a ou 18b reliées par des faces latérales planes inclinées 19a ou 19b. Pour chacune des puces élémentaires 16a, 16b, les faces latérales planes inclinées, 19a ou 19b, forment un angle aigu avec la grande base, 18a ou 18b correspondante et sont convergentes. Un composant microélectronique 23a, 23b est situé au niveau de la petite base 17 (respectivement 17a, 17b) de chacune des puces élémentaires 16a, 16b. Les puces élémentaires 16a, 16b sont solidarisées par leurs petites bases 17a, 17b de telle manière que leurs faces latérales inclinées 19a, 19b constituent au moins une rainure de logement. Sur la figure 2, deux rainures de logement 20 et 21 sont représentés. Les rainures de logement 20, 21 présentent donc une section en forme de V (plus particulièrement en forme de V tronqué sur la figure 2) et constituent les faces latérales 6 et 7 de la puce microélectronique 1. Les grandes bases 18a, 18b sont parallèles et constituent les faces principales 5, 6 de la puce microélectronique 1 de la figure 2. Les rainures de logement 20, 21 peuvent recevoir les fils 10 et 11 de manière analogue à la puce microélectronique 1 de la figure 1.

Les puces élémentaires 16a et 16b sont, par exemple, assemblées l'une à l'autre par collage, une couche de colle 22 étant alors intercalée entre les petites bases 17a, 17b. La colle peut être une résine, isolante, conductrice ou électroactive. Lors de cet assemblage, en déposant les résines sélectivement, il est possible de réaliser des liaisons électriques entre les composants microélectroniques 23a, 23b et/ou des fonctions de capteur de pression ou de génération d'énergie (piézoélectricité) grâce à des insertions en résine électroactive. L'assemblage des puces élémentaires 16a, 16b peut aussi être réalisé par collage moléculaire. Dans ce dernier cas, la couche de colle 22 est absente.

Les rainures de logement 20, 21 sont revêtues par une couche électriquement conductrice, respectivement 24, 25, déposée sur les faces latérales planes inclinées 19a, 19b. Cette disposition permet d'utiliser des fils 10, 11 de trame ou de chaîne qui sont conducteurs électriquement et d'assurer un contact électrique avec ces fils 10, 11. Les couches électriquement conductrices 24, 25 sont reliées électriquement, de manière classique, aux composants microélectroniques 23a, 23b, par exemple, par l'intermédiaire de pistes conductrices 26. Les pistes 26 peuvent être réalisées dans le même matériau que les couches 24, 25, éventuellement pendant le dépôt des couches 24, 25.

Dans le cas où le collage est réalisé par une résine polymère électroactive (qui permet de constituer une source locale d'énergie), les couches 24, 25 peuvent être supprimées. Sinon, les fils 10, 11 peuvent être affectés à des fonctions électroniques différentes de l'alimentation en énergie et les couches 24, 25 sont affectées à d'autres fonctions que l'alimentation.

En variante, les composants microélectroniques 23a, 23b peuvent être formés au niveau des grandes bases 18a, 18b. Un tel composant pourra alors être relié électriquement avec une couche électriquement conductrice 24, 25 par l'intermédiaire d'un via traversant (non représenté sur la figure 2).

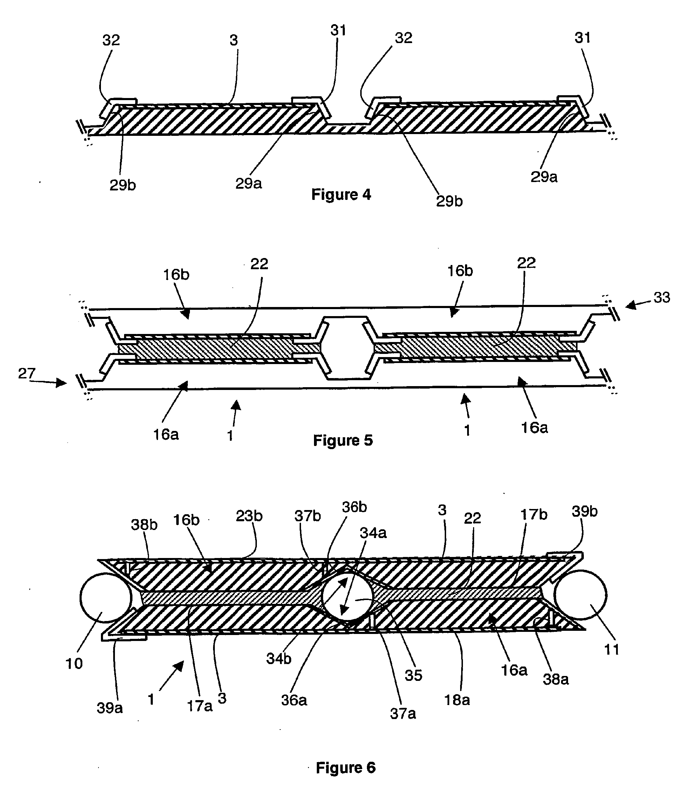

La puce microélectronique 1 de la figure 2 peut être obtenue par le procédé de fabrication illustré aux figures 3 à 5. Dans une première étape (figure 3), on fabrique simultanément, sur une même première plaquette 27, une pluralité de puces élémentaires 16a séparées par des rainures 28 en forme de V comprenant chacune deux parois 29a, 29b convergentes. Chaque rainure 28 est formée dans la face de la plaquette 27 dans laquelle sont constituées les petites bases 17. Les parois 29a, 29b des rainures 28 sont reliées par un fond plat 30, parallèle à la face de la plaquette 27 dans laquelle sont constituées les petites bases 17. Deux réseaux de rainures 28 parallèles sont réalisés. Les rainures 28 des deux réseaux sont orthogonales entre elles. Ainsi, une paire de rainures 28 adjacentes de l'un des réseaux délimite, en combinaison avec paire de rainures 28 adjacentes de l'autre réseau, une petite base 17, de forme rectangulaire ou carrée. Les puces élémentaires 16a sont réparties en lignes et colonnes dans le plan de la plaquette 27. Un composant microélectronique est formé au niveau de chacune des petites bases 17. La figure 3 illustre, en coupe, deux puces élémentaires 16a adjacentes, séparées par une rainure 28. Une deuxième plaquette 33 analogue (représentée figure 5) comporte une pluralité de puces élémentaires 16b.

Dans une étape suivante (figure 4), un matériau électriquement conducteur est déposé sur la face de la plaquette 27 dans laquelle sont constituées les petites bases 17, de manière à former, dans chaque puce élémentaire 16a, un premier contact 31 disposé entre le composant microélectronique 3 et la paroi 29a d'une rainure 28 adjacente, ainsi qu'un deuxième contact 32 disposé entre le composant 3 et la paroi 29b de la rainure 28 adjacente parallèle. De tels contacts (non représentés) peuvent également être réalisés pour les parois des rainures 28 du réseau perpendiculaire.

Dans une étape ultérieure (figure 5), la plaquette 27 comportant les puces élémentaires 16a est collée à la plaquette 33 comportant les puces élémentaires 16b. Les plaquettes 27 et 33 sont collées par leurs faces comportant les rainures 28, de manière à ce que les rainures 28 soient superposées. L'ensemble ainsi réalisé comporte une pluralité de puces microélectroniques 1 selon la figure 2. Ces puces microélectroniques 1 sont réparties en lignes et en colonnes, séparées entre elles par les fonds plats 30 des rainures 28 des plaquettes 27 et 33. Le matériau utilisé pour le collage constitue, pour chaque puce microélectronique 1, la couche de colle 22 de la figure 2. L'assemblage des plaquettes 27 et 33 peut aussi être réalisé par collage moléculaire. Dans ce dernier cas, les couches de colle 22 sont absentes. De manière facultative, un rabotage des faces arrières (opposées aux faces où sont formées les rainures 28) des plaquettes 27, 33, peut-être réalisé afin d'amincir les puces microélectroniques 1 ainsi formées.

Dans une dernière étape, les plaquettes 27, 33, collées l'une à l'autre, sont découpées au niveau des rainures 28 de manière à séparer les puces microélectroniques 1 les unes des autres. Ce découpage peut être réalisé par toute technique adaptée, par exemple, par sciage à l'aide d'un scie circulaire diamant, par gravure sèche ou humide, par ablation laser, par gravure chimique assistée par laser...

La figure 6 illustre une variante de la puce 1 selon la figure 2. Dans cette variante, les composants microélectroniques 23a, 23b des puces élémentaires 16a, 16b sont formés au niveau des grandes bases 18a, 18b. La petite base 17a, 17b de chacune des puces élémentaires 16a 16b comporte une rainure additionnelle 34a, 34b parallèle aux rainures de logement 20, 21 en forme de V. Les rainures additionnelles 34a, 34b sont superposées pour constituer un logement additionnel pour un élément filaire, tel qu'un fil 35 intercalé entre les fils 10 et 11. Les rainures additionnelles 34a, 34b sont revêtues par une couche électriquement conductrice, respectivement 36a, 36b, reliée au composant électronique, 23a ou 23b, associé par l'intermédiaire d'un via traversant, 37a ou 37b.

Compte tenu de la disposition des composants microélectroniques 23a, 23b, ces derniers peuvent, comme précédemment, être reliés aux couches électriquement conductrices 24, 25 par un via traversant 38a, 38b ou par une piste conductrice 39a, 39b.

Le fil 35 peut être destiné à assurer une interconnexion directe entre deux puces microélectroniques 1 ou bien peut constituer une antenne par fil métallique rayonnant. Le fil 35 peut également être une fibre piézoélectrique, de manière à constituer l'alimentation en énergie.

Dans toutes les variantes qui viennent d'être décrites ci-dessus, il est possible d'améliorer le contact entre les fils 10, 11, 35 et les rainures de logement 8, 9, 20, 21 et les rainures additionnelles 34a, 34b en ayant recours à une colle conductrice par exemple à deux composants, qui réticule ou polymérise lorsque les deux composants sont en contact. Les fils 10, 11, 35 sont alors enrobés avec l'un des composants tandis que l'autre composant est déposé dans les rainures 8, 9, 20, 21, 34a, 34b.

L'élément filaire peut être fixé par tout autre moyen, par exemple, par soudure par apport de matériau, par plasma, par électrolyse, ultrason... Dans un autre mode de réalisation de l'invention, la puce microélectronique 1 comporte au moins un évidement 8, 9, c'est-à-dire une rainure ou un trou, dans une de ses faces principales 4, 5. Ceci permet son intégration, par exemple dans un textile, dans un mode dit parallèle, c'est-à-dire que l'axe de l'élément filaire 10, 11 aux abords immédiats de sa fixation à la puce est sensiblement parallèle aux faces principales 4, 5 de la puce microélectronique 1.

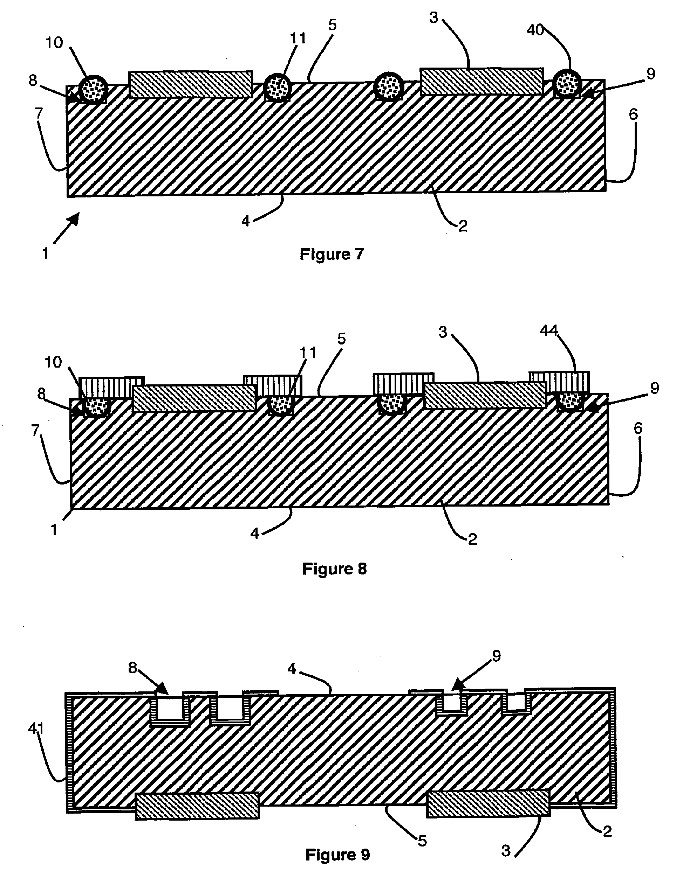

Comme illustré sur la figure 7, une puce microélectronique 1 comportant un substrat 2 plan, par exemple en silicium, est munie d'au moins un composant microélectronique 3. La puce 1 comporte au moins un évidement 8, 9 par exemple une tranchée ou un trou non débouchant, réalisé soit sur une face avant 5, c'est-à-dire sur la face comprenant les composants microélectroniques 3, soit sur une face arrière 4, sensiblement parallèle à la face avant. Ces évidements 8, 9 ont pour but d'assurer une liaison mécanique entre la puce 1 et l'élément filaire 10, 11 auquel la puce 1 va être fixée. La forme ainsi que les dimensions de l'évidement 8, 9, sont fonction des caractéristiques mécaniques et dimensionnelles de l'élément filaire 10, 11. A titre d'exemple, une rainure présentant une section concave, par exemple une section carrée ou circulaire, en V ou V tronquée peut être utilisée.

Dans un mode de réalisation préférentiel, afin d'assurer une bonne fixation de la puce 1 avec les éléments filaires 10, 11 appartenant, par exemple, à un tissu sur lequel la puce doit être intégrée, un composé fixant, par exemple, une colle, peut être utilisé.

La fixation par encastrement d'au moins un élément filaire 10, 11 dans les évidements 8, 9 de la puce 1 permet d'assurer une connexion mécanique rigide entre la puce et l'élément filaire au niveau de la puce. Un élément filaire constitue alors une connexion mécanique souple entre deux puces qui y sont rattachées.

La puce présente, de préférence, au sein de l'évidement 8, 9 une surface conductrice constituant un élément de connexion électrique. L'élément filaire 10, 11, constituant un support mécanique souple pour la puce 1, constitue alors simultanément une connexion électrique entre la puce 1 et l'extérieur. Ainsi, les composants microélectroniques 3 de la puce 1, connectés électriquement à l'élément filaire 10, 11, sont alors en mesure d'être électriquement alimentés et/ou de communiquer avec d'autres puces 1 également connectées mécaniquement et électriquement à l'élément filaire 10, 11.

En variante, l'élément filaire 10, 11 peut être utilisé par la puce 1 en tant qu'antenne de communication (émission et/ou réception).

De manière conventionnelle, une pluralité de puces microélectroniques 1 sont réalisées simultanément sur un substrat 2. Sur chaque puce 1, au moins un évidement 8, 9 est réalisé afin de pouvoir y encastrer un élément filaire 10, 11.

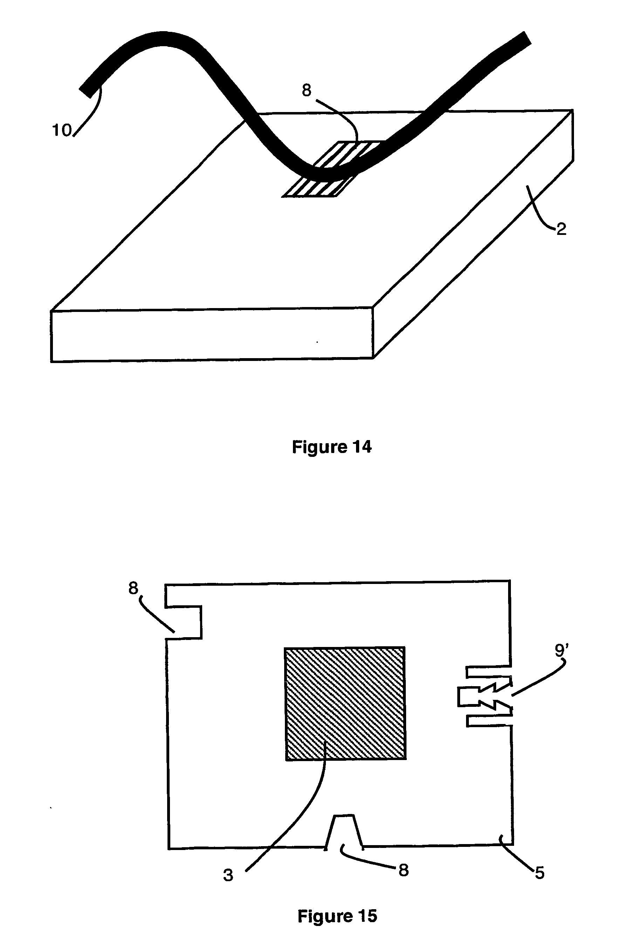

Les évidements 8, 9, par exemple sous forme de rainures peuvent être réalisés par gravure chimique, par exemple au moyen d'une solution de KOH, ou par gravure plasma ou par sciage. Le choix des dimensions de la rainure 8, 9 est choisi en fonction des caractéristiques de l'élément filaire 10, 11 à intégrer dans la rainure 8, 9 afin d'assurer la meilleure tenue mécanique possible. La profondeur et la largeur de la rainure peuvent typiquement varier entre 20 µm et 100 µm pour l'intégration dans la rainure d'un élément filaire de l'ordre de 20µm à 100 µm de diamètre. De plus, les flancs des rainures peuvent être amincis de façon à leur conférer une souplesse permettant à l'élément filaire de s'encastrer en force. L'amincissement est réalisé, par exemple, au moyen de deux entailles formées de part et d'autre de l'évidement et illustré à la figure 15 dans un autre mode de réalisation.

La profondeur de la rainure 8, 9 peut être
- soit inférieure ou égale au diamètre de l'élément filaire de façon à la laisser affleurer à la surface,
- soit supérieure ou égale de façon à obtenir une plus grande souplesse des flancs pour l'encastrement.

Dans le cas où les rainures 8, 9 sont formées sur la face avant 5, elles sont réalisées au sein des composants microélectroniques 3 ou à proximité (figure 7). Dans ce dernier cas de figure, les évidements 8, 9 sont connectés électriquement au composant microélectronique 3 de la puce pour assurer la communication électrique de la puce 1 avec l'extérieur. La connexion électrique entre le composant microélectronique 3 et un évidement 8, 9 est effectuée de manière classique par tout moyen approprié, par exemple par la réalisation d'une piste métallique par jet d'encre, sérigraphie ou utilisation d'une colle conductrice.

Un élément filaire 10, 11, appartenant par exemple à un tissu, est ensuite encastré, préférentiellement de force, dans la rainure 8, 9. Lorsque l'élément filaire 10, 11 doit assurer la communication électrique avec la puce 1 microélectronique, tout contact du matériau conducteur de l'élément filaire 10, 11 avec des zones non désirées de la puce microélectronique 1 doit être évité. Dans le cas d'une utilisation d'un élément filaire en matériau conducteur, ce dernier peut être avantageusement enrobé par un matériau isolant 40 (figure 7).

Dans le cas où l'élément filaire 10, 11 est en matériau conducteur et ne comporte pas d'enrobage par un matériau isolant, une isolation électrique du fond de l'évidement 8, 9 peut être réalisée de façon connue. Par ailleurs, si la couche en matériau isolant 40 enrobant l'élément filaire 10, 11 est en polymère thermodurcissable, une insertion à chaud est alors préférentiellement choisie pour permettre de faciliter l'encastrement et le collage de l'élément filaire 10, 11 à l'intérieur de la rainure 8, 9 et donc son insertion au sein, par exemple, d'un tissu.

Dans la variante illustrée à la figure 8, l'enrobage de l'élément filaire 10, 11 est partiellement éliminé après l'insertion de l'élément filaire dans la rainure correspondante, afin d'autoriser une connexion électrique entre l'élément filaire et le composant microélectronique 3 de la puce 1. Le retrait, de la couche en matériau isolant 40 est réalisé par tout moyen connu, par exemple, par grattage avec une lame ou bien par fluage à chaud pendant ou après l'encastrement. La connexion avec le composant 3 est ensuite réalisée par formation d'une piste métallique 44 recouvrant la partie dénudée de l'élément filaire et la connectant à un plot de connexion (non représenté) du composant 3. Une telle piste peut classiquement être obtenue par jet d'encre, sérigraphie ou dépôt d'une colle conductrice.

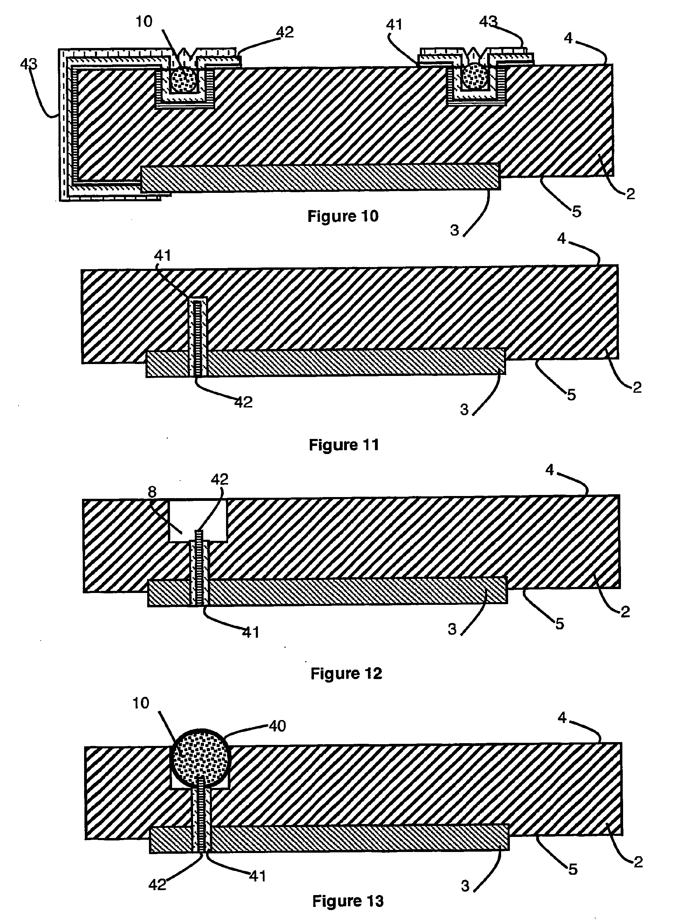

Dans une autre variante de réalisation illustrée aux figures 9 et 10, l'intégration des rainures 8, 9 est réalisée dans la face arrière 4. De cette façon, la surface de la face avant 5, dite face « active » est préservée et une plus grande densité d'intégration peut être alors obtenue en répartissant sur les faces principales 4, 5 les différentes fonctionnalités de la puce 1. Si l'on souhaite utiliser une pluralité d'éléments filaires 10, 11 comme conducteurs électriques, il est avantageux d'utiliser une intégration sur la face arrière 4. En effet, il est alors possible d'intégrer un plus grand nombre d'éléments filaires en utilisant la face arrière, par exemple, 9 ou 10 fils par mm avec des fils parallèles espacés de 80 µm.

L'élément filaire 10, 11 disposé dans un évidement 8, 9 situé sur la face arrière 4, est avantageusement en matériau conducteur et préférentiellement dépourvu d'enrobage en matériau isolant. Un contact électrique est réalisé au sein de la puce microélectronique 1 afin de permettre la connexion de l'élément filaire 10, 11 en matériau conducteur situé sur la face arrière 4 et du composant microélectronique 3 situé sur la face avant 5. Ainsi, l'évidement 8, 9 forme un logement pour un élément filaire qui constitue simultanément une connexion électrique entre la puce et l'extérieur tout en assurant un support mécanique souple pour la puce 1.

Dans le mode de réalisation illustré sur la figure 9, après la réalisation au sein de la face arrière 4 d'au moins un évidement 8, 9, une couche d'un matériau isolant 41 est tout d'abord déposée sur le substrat, puis structurée pour isoler électriquement du substrat 2 au moins les évidements 8, 9 et de futures pistes conductrices de connexion au composant 3. Le matériau isolant 41 est, par exemple, du nitrure de silicium ou de l'oxyde de silicium dont l'épaisseur est typiquement de l'ordre de 100 à 500 nm.

Puis (figure 10), un matériau conducteur 42 est déposé sur la couche 41 pour réaliser une connexion électrique entre le composant microélectronique et l'intérieur de la rainure. Le matériau conducteur 42 est, par exemple, constitué par un empilement de 30 nm de Titane recouvert de 300 nm de Cuivre. Classiquement, ce matériau conducteur est également structuré afin d'éviter tout court-circuit.

Les éléments filaires 10, 11 peuvent ensuite être insérés dans les évidements 8, 9 afin d'intégrer la puce microélectronique 1 par exemple au sein d'un tissu. Avantageusement, un métal 43 de renfort peut être déposé, par exemple par électrolyse après insertion des éléments filaires 10, 11. Le métal 43 de renfort est de préférence constitué par une couche de nickel ou de cuivre, dont l'épaisseur est typiquement comprise entre 2 et 30 µm. Cette étape permet non seulement d'améliorer la connexion entre les composants 3 de la face avant 5 et les éléments filaires 10, 11 de la face arrière 4 mais aussi de bloquer ou souder l'élément filaire 10, 11 dans son logement.

Un autre procédé de réalisation d'une puce dans laquelle les rainures sont formées au niveau de la face arrière est illustré sur les figures 11 à 13.

Comme illustré sur la figure 11, une cavité, avantageusement un trou, est gravée au sein de la puce microélectronique 1, à partir de la face avant 5, et s'enfonce dans le substrat. La profondeur du trou est de préférence comprise entre 100 et 200 µm. Le trou a un diamètre typique de l'ordre de 100 µm et peut avantageusement être terminé par une forme pointue. Le trou ainsi réalisé est ensuite revêtu, par toute technique adaptée, par un matériau isolant 41, par exemple un oxyde de silicium PECVD, dont l'épaisseur est comprise, par exemple, entre 100 et 300 nm. Puis, un matériau conducteur 42, de préférence dur, par exemple, du nickel ou du tungstène, remplit la cavité ainsi recouverte. Le matériau conducteur 42 ainsi formé est connecté au composant microélectronique 3.

Comme illustré sur la figure 12, un évidement 8, par exemple une rainure, partant de la face arrière 4 est ensuite gravé en regard du trou. La rainure 8 est avantageusement plus large que le trou. La profondeur de la rainure 8 est avantageusement définie de manière à ce que le matériau conducteur 42 provenant de la face avant fasse saillie au fond de la rainure 8, de préférence, d'une hauteur de l'ordre de 10 à 20 µm et forme ainsi une pointe. La rainure 8 est réalisée par toute technique adaptée, par exemple par gravure sélective du matériau diélectrique du substrat 2 par rapport au matériau isolant 41.

La couche de matériau isolant 41, en saillie dans le fond de la rainure 8, est ensuite retirée par tout procédé connu, par exemple, par gravure plasma ou par gravure humide.

Comme illustré sur la figure 13, un élément filaire 10, par exemple en matériau conducteur, avantageusement enrobé d'une couche de matériau isolant 40, est ensuite inséré dans la rainure 8 afin d'intégrer la puce microélectronique 1 au sein d'une structure souple. Le film isolant 40 enrobant le matériau conducteur peut être, par exemple, un vernis ou un polymère thermoplastique. Lorsque l'élément filaire 10 est inséré dans la rainure 8, la partie en saillie de matériau conducteur 42, en forme de pointe, provenant de la face avant 5, perfore le film isolant 40 enrobant l'élément filaire 10 et réalise ainsi le contact électrique de ce dernier avec le composant microélectronique 3.

Si l'isolant 40 enrobant l'élément filaire 10 est un polymère thermodurcissable, le fil est, de préférence, inséré à chaud pour faciliter l'indentation de la pointe de matériau conducteur 42 dans l'élément filaire et coller ce dernier à l'intérieur de la rainure 8.

Dans une variante de réalisation qui ne fait pas partie de l'invention, illustrée sur la figure 14, l'évidement est un trou 8, non traversant, réalisé sur une des faces principales 4, 5 afin d'y encastrer un élément filaire 10.

Dans un autre mode de réalisation qui ne fait pas partie de l'invention, dit perpendiculaire, l'axe de l'élément filaire 10 est perpendiculaire aux faces principales 4, 5 de la puce microélectronique 1 lors de l'encastrement de la puce dans la structure souple comme un tissu.

Dans ce mode de réalisation, illustré en vue de dessus sur la figure 15, au moins un évidement traversant 8, 9', par exemple un trou, est réalisé dans une puce microélectronique 1, de préférence, en périphérie de la puce. Ce trou 8, 9' peut être obtenu par tout moyen connu, par exemple, par une gravure plasma ou par laser. La partie évidée de la puce 1 peut être par exemple de forme carrée, en forme de V ou de C ou alors présenter (trou 9') une structure visant à bloquer mécaniquement (« grip fil ») un élément filaire 10. Les parois internes du trou 9' ne sont pas lisses mais présentent des pointes acérées, par exemple les faces latérales des rainures comportent des griffes, destinées à entailler la gaine isolante de l'élément filaire lors de l'introduction de celui-ci dans le trou 9' et à maintenir l'élément filaire.

Dans la variante de réalisation illustrée à la figure 15, l'évidement 9' comporte à proximité, deux entailles situées de part et d'autre de l'évidement afin de lui donner la souplesse nécessaire pour supporter les sollicitations durant l'insertion de l'élément filaire 10 et/ou les variations de dilatation thermique entre l'élément filaire 10 et la puce 1.

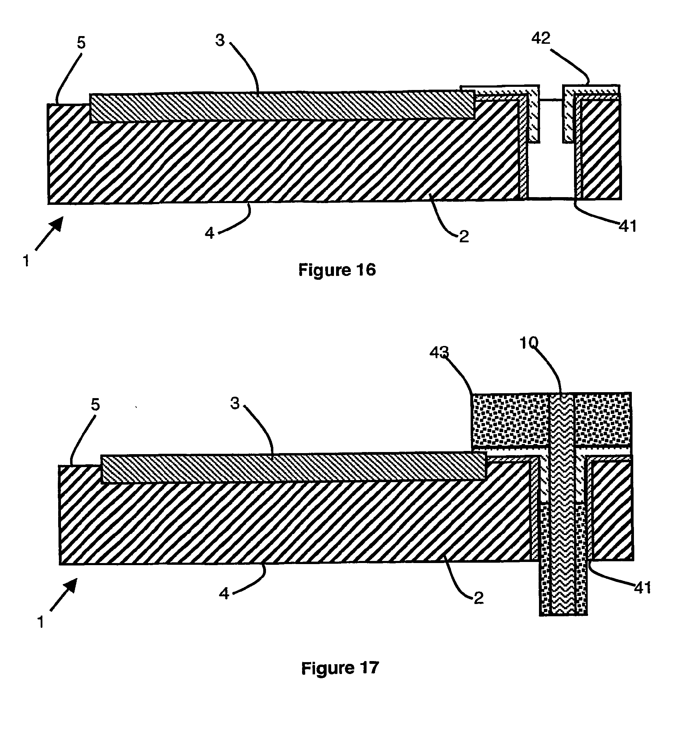

Comme illustré en coupe sur les figures 16 et 17, dans le cas d'une utilisation d'un élément filaire 10 conducteur, l'isolation électrique de l'intérieur des trous 8, 9 est réalisée, par dépôt par exemple par PECVD, d'un matériau isolant 41, par exemple de l'oxyde de silicium ou du nitrure de silicium, d'une épaisseur typique de l'ordre de 1 à 3 µm. La couche de matériau isolant 41 est ensuite structurée, de façon connue pour permettre l'accès à des plots de contact connectés au composant 3 de la puce microélectronique 1.

Le dépôt d'un matériau conducteur 42 est ensuite réalisé, par exemple 30 nm de titane surmonté de 300 nm de cuivre ou alors une bicouche titane/nickel. Le matériau conducteur 42 est ensuite structuré pour que la surface intérieure des trous soit connectée électriquement au composant 3.

Comme précédemment, un dépôt par électrolyse d'un métal 43 de renfort peut être avantageusement réalisé. Le métal de renfort va alors recouvrir l'élément filaire 10 et les zones de contact avec la puce et assurer ainsi une meilleure tenue mécanique. L'épaisseur de la couche de métal 43 est typiquement dans la gamme 1-30 µm, par exemple de l'ordre de 5 µm.

Comparée aux autres techniques, l'électrolyse présente l'avantage d'être réalisée à froid et de ne pas constituer ultérieurement une limitation thermique.

Au moins deux puces 1 peuvent être intégrées sur au moins un élément filaire 10 de manière à former une microstructure ou un assemblage. Cet assemblage comporte des puces fixées chacune sur l'élément filaire 10, les puces 1 étant connectées entre elles par l'élément filaire qui constitue un support mécanique souple. Les évidements 8, 9 assurent dans cet assemblage, le maintien mécanique de la puce microélectronique 1, sur les éléments filaires qui servent à sa communication électrique avec l'extérieur ainsi qu'à son alimentation.

L'assemblage peut comporter une pluralité de puces 1 organisées sous la forme d'une matrice, des éléments filaires 10, 11 assurant, suivant les deux directions principales de la matrice, la connexion mécanique souple des différentes puces et, avantageusement, la connexion électrique des puces.

Les puces 1 au sein de l'assemblage peuvent être alimentées et/ou communiquer entre elles ou avec l'extérieur au moyen, par exemple, d'au moins un élément filaire en matériau conducteur ou utiliser une communication optique ou par ondes électromagnétiques.

Une fois l'assemblage réalisé, ce dernier peut être au moins partiellement encapsulé par toute technique adaptée, afin de le protéger des agressions de l'environnement extérieur et/ou pour assurer une tenue mécanique supérieure. Il peut, par exemple, être encapsulé, par exemple, au sein d'une gaine pouvant être enroulée et/ou déroulée.

Plusieurs puces microélectroniques 1, notamment selon les figures 1 et 2, peuvent être intégrées dans un textile par maintien entre deux mêmes fils conducteurs adjacents, de manière à constituer un train de puces où chacune d'elles est associée à une fonction particulière (source d'énergie, récupération d'énergie, traitement numérique de données...). L'alimentation peut être réalisée par l'intermédiaire d'une puce métallisée sur ses grandes faces reliées à un générateur extérieur par exemple par un système de pinces et en contact avec les fils d'alimentation du textile. Les puces peuvent également, dans ce cas, assurer la même fonction (par exemple de capteur de pression ou de température). Dans ce cas, il est possible d'interposer une puce selon la figure 6 entre deux trains de puces selon les figures 1 et 2, de manière à relier les trains de puces entre eux par un bus série constitué par le fil 35. Les fils 10 et 11 peuvent alors servir à l'alimentation en énergie. Une alimentation thermoélectrique est également envisageable.

Des puces microélectroniques selon la figure 5 peuvent être utilisées pour la confection d'un tissu scintillant. Dans ce cas, l'une des puces élémentaires est une micro-batterie, l'autre puce élémentaire est un dispositif de contrôle de charge de cette batterie et un dispositif qui allume une diode dès qu'un seuil d'énergie est atteint. Entre les puces élémentaires, des fibres piézoélectriques assurent une récupération d'énergie lors des mouvements du tissu de manière à recharger la batterie. Les puces microélectroniques sont insérées lors du tissage, et ie tissu se met à scintiller lorsqu'il présente des mouvements suffisants. Une alimentation thermoélectrique est également envisageable.

La puce peut, par exemple, être un composant RFID (radio frequency identification device) et les fils constituent alors à la fois des antennes et l'alimentation. Ces puces peuvent, par exemple, servir à la gestion d'inventaires.

Des puces microélectroniques selon l'invention peuvent notamment être utilisées pour réaliser un tissu écran. Dans ce cas, l'une des puces élémentaires est composée d'un substrat en saphir sur lequel est implantée une petite matrice de diodes multicolores (par exemple 16 par 16). L'autre puce élémentaire contient une logique de mémorisation et de multiplexage qui récupère les pixels à afficher grâce à une liaison série. Un film holographique est placé sur le tissu de manière à diffuser la lumière produite par le tissu.

Le composant microélectronique des puces selon l'invention peut également être un actionneur (par exemple un générateur de gaz explosif ou non). L'adressage de telles puces lorsqu'elles sont montées en chaînes est réalisé par l'un des fils conducteurs du textile. Il est ainsi, par exemple, possible de maintenir à pression constante un objet gonflable (pneu, ballon, bateau). L'actionnement peut également être constitué de micro actuateurs.

Il est en outre possible de réaliser une tapisserie constituant une interface homme/machine, ou former des antennes de télé alimentation de capteurs placés dans un milieu solide (béton).

Dans tous les domaines utilisant de la microélectronique, il est nécessaire de rendre les dispositifs les plus compacts possible. L'invention peut être utilisée dans ce but en assemblant verticalement des puces afin de constituer des blocs compacts mais où cependant peuvent être aménagés des espaces interpuces (grâce aux éléments filaires qui maintiennent les puces espacées) afin d'améliorer leur refroidissement lors du fonctionnement.

## Revendications

1. Puce microélectronique (1) comportant un élément filaire électriquement conducteur (10,11), deux faces principales parallèles avant et arrière (4, 5), des faces latérales (6, 7) et un évidement formant un logement pour l'élément filaire électriquement conducteur (10, 11), l'évidement étant une rainure placée sur l'une des faces principales ou latérales, la rainure ayant un axe parallèle aux faces principales pour une fixation par encastrement de l'élément filaire électriquement conducteur (10, 11) dans ladite rainure, la puce étant munie d'au moins un élément de connexion électrique destiné à connecter un composant microélectronique intégré dans la puce avec l'élément filaire, l'élément de connexion électrique étant, dans le cas d'une rainure placée sur une face latérale, au moins en partie constitué par une couche électriquement conductrice qui revêt au moins en partie ladite rainure; puce **caractérisée en ce que** l'encastrement de l'élément filaire électriquement conducteur (10, 11) dans ladite rainure est selon l'axe longitudinal de cette dernière, ledit élément filaire électriquement conducteur (10, 11) constituant un support mécanique souple pour ladite puce.

2. Puce selon la revendication 1, **caractérisée en ce qu'**une couche électriquement conductrice (12, 13, 24, 25) revêt au moins en partie l'évidement (8, 9, 20, 21).

3. Puce selon l'une des revendications 1 et 2, **caractérisée en ce que** ladite rainure est située sur au moins une face latérale (6, 7).

4. Puce selon l'une des revendications 1 et 2, **caractérisée en ce que** ladite rainure est située sur au moins une face principale (4, 5).

5. Puce selon l'une quelconque des revendications 1 à 4, **caractérisée en ce que** ladite rainure (8, 9) comporte une section concave, carrée ou circulaire.

6. Puce selon l'une quelconque des revendications 1 à 5, **caractérisée en ce que** ladite rainure (20, 21) comporte une section en forme de V ou de V tronqué.

7. Puce selon la revendication 3, **caractérisée en ce qu'**elle comporte une première et une deuxième puces élémentaires (16a, 16b) comprenant chacune une petite base (17a, 17b) et une grande base (18a, 18b) parallèles reliées par au moins une face latérale plane inclinée (19a, 19b) formant un angle aigu avec la grande base (18a, 18b), les première et deuxième puces élémentaires (16a, 16b) étant solidarisées par leurs petites bases (17a, 17b) de manière que leurs faces latérales planes inclinées (19a, 19b) constituent ladite rainure (20, 21) en forme de V ou de V tronqué.

8. Puce selon la revendication 7 **caractérisée en ce que** la petite base (17a, 17b) des première et deuxième puces élémentaires (16a, 16b) comporte une rainure additionnelle (34a, 34b) parallèle à la rainure en forme de V (20, 21), les rainures additionnelles (34a, 34b) des première et deuxième puces élémentaires (16a, 16b) étant superposées pour constituer un logement additionnel pour un élément filaire (35).

9. Puce selon la revendication 4, **caractérisée en ce que** le composant microélectronique est intégré sur la face principale avant, et **en ce que** ladite rainure étant située sur la face principale arrière, ledit au moins un élément de connexion électrique est un contact électrique traversant la puce depuis la face avant jusqu'audit évidement.

10. Procédé de fabrication d'une puce microélectronique (1) selon la revendication 3, **caractérisé en ce qu'**il comporte :
- la fabrication simultanée, sur une même plaquette (27, 33), d'une pluralité de puces élémentaires (16a, 16b), séparées par des rainures en forme de V (28) comprenant chacune deux parois convergentes (29a, 29b),
- le dépôt d'un matériau électriquement conducteur formant, dans chaque puce élémentaire (16a, 16b), au moins un contact (31, 32) disposé entre un composant microélectronique (23a, 23b) intégré dans ladite puce élémentaire (16a, 16b) et une paroi (29a, 29b) d'une rainure (28) adjacente,
- l'assemblage de deux plaquettes (27, 33) par leurs faces comportant les rainures (28), de manière à ce que les rainures (28) se superposent,
- la découpe des plaquettes (27, 33) assemblées au niveau des rainures (28).

11. Microstructure comportant au moins des première et deuxième puces selon l'une quelconque des revendications 1 à 9, **caractérisée en ce que** l'élément filaire de la première puce et l'élément filaire de la deuxième puce forment un élément filaire unique, l'élément filaire unique assurant simultanément la connexion électrique et une connexion mécanique souple entre les deux puces.

12. Microstructure selon la revendication 11, **caractérisée en ce que** l'élément filaire unique est collé dans les évidements.

13. Microstructure selon la revendication 11, **caractérisée en ce que** l'élément filaire unique est soudé dans les évidements.

## Patentansprüche

1. Mikroelektronischer Chip (1), umfassend ein elektrisch leitendes Fadenelement (10, 11), zwei parallele Hauptseiten, eine vordere und eine hintere, (4, 5), Seitenflächen (6, 7) sowie eine Ausnehmung, die eine Aufnahme für das elektrisch leitende Fadenelement (10, 11) bildet, wobei die Ausnehmung eine an einer der Hauptseiten oder Seitenflächen angeordnete Nut ist, wobei die Nut eine zu den Hauptseiten parallele Achse für eine Befestigung des elektrisch leitenden Fadenelement (10, 11) in der Nut durch Einbettet aufweist, wobei der Chip mit wenigstens einem Element zur elektrischen Verbindung ausgestattet ist, das dazu bestimmt ist, ein in den Chip integriertes mikroelektronisches Bauelement mit dem Fadenelement zu verbinden, wobei das Element zur elektrischen Verbindung im Fall einer an einer Seitenfläche angeordneten Nut wenigstens teilweise durch eine elektrisch leitende Schicht gebildet ist, welche die Nut wenigstens teilweise überzieht, Chip, **dadurch gekennzeichnet, dass** die Einbettung des elektrisch leitenden Fadenelements (10, 11) in die Nut entlang der Längsachse letzterer erfolgt, wobei das elektrisch leitende Fadenelement (10, 11) einen mechanischen flexiblen Träger für den Chip bildet.

2. Chip nach Anspruch 1, dadurch gekennzeichet, dass eine elektrisch leitende Schicht (12, 13, 24, 25) die Ausnehmung (8, 9, 20, 21) wenigstens teilweise überzieht.

3. Chip nach einem der Ansprüche 1 und 2, **dadurch gekennzeichnet, dass** die Nut an wenigstens einer Seitenfläche (6, 7) gelegen ist.

4. Chip nach einem der Ansprüche 1 und 2, **dadurch gekennzeichnet, dass** die Nut an wenigstens einer Hauptseite (4, 5) gelegen ist.

5. Chip nach einem der Ansprüche 1 bis 4, **dadurch gekennzeichnet, dass** die Nut (8, 9) einen konkaven, quadratischen oder kreisförmigen Querschnitt aufweist.

6. Chip nach einem der Ansprüche 1 bis 5, **dadurch gekennzeichnet, dass** die Nut (20,21) einen Querschnitt mit V- oder abgestumpfter V-Fonn aufweist.

7. Chip nach Anspruch 3, **dadurch gekennzeichnet, dass** er einen ersten und einen zweiten Einzelchip (16a, 16b) umfasst, die jeweils eine kleine Grundseite (17a, 17b) und eine große Grundseite (18a, 18b) aufweisen, welche parallel sind und durch wenigstens eine geneigte ebene Seitenfläche (19a, 19b), die mit der großen Grundseite (18a, 18b) einen spitzen Winkel bildet, verbunden sind, wobei der erste und der zweite Einzelchip (16a, 16b) über ihre kleinen Grundseiten (17a, 17b) derart fest verbunden sind, dass ihre geneigten ebenen Seitenflächen (19a, 19b) die Nut (20, 21) mit V- oder abgestumpfter V-Form bilden.

8. Chip nach Anspruch 7, **dadurch gekennzeichnet, dass** die kleine Grundseite (17a, 17b) des ersten und des zweiten Einzelchips (16a, 16b) eine zusätzliche Nut (34a, 34b), welche zu der V-förmigen Nut (20, 21) parallel verläuft, umfasst, wobei die zusätzlichen Nuten (34a, 34b) des ersten und des zweiten Einzelchips (16a, 16b) übereinander angeordnet sind, um eine zusätzliche Aufnahme für ein Fadenelement (35) zu bilden.

9. Chip nach Anspruch 4, **dadurch gekennzeichnet, dass** das mikroelektronische Bauelement an der vorderen Hauptseite integriert ist und dass, wenn die Nut an der hinteren Hauptseite gelegen ist, das wenigstens eine Element zur elektrischen Verbindung ein elektrischer Kontakt ist, der den Chip von der Vorderseite bis zu der Ausnehmung durchquert.

10. Verfahren zur Herstellung eines mikroelektronischen Chips (1) nach Anspruch 3, **dadurch gekennzeichnet, dass** es umfasst:
- die gleichzeitige Herstellung, auf einem gleichen Wafer (27, 33), einer Vielzahl von Einzelchips (16a, 16b), die durch V-förmige Nuten (28), welche jeweils zwei konvergente Hände (29a, 29b) umfassen, getrennt sind,
- das Abscheiden eines elektrisch leitenden Materials, das bei jedem Einzelchip (16a, 16b) wenigstens einen Kontakt (31, 32) bildet, der zwischen einem in den Einzelchip (16a, 16b) integrierten mikroelektronischen Bauelement (23a, 23b) und einer Wand (29a, 29b) einer benachbarten Nut (28) angeordnet ist,
- das Verbinden von zwei Wafern (27, 33) über ihre die Nuten (28) umfassenden Seiten, so dass die Nuten (28) übereinander liegen,
- das Zerschneiden der verbundenen Wafer (27, 33) im Bereich der Nuten (28).

11. Mikrostruktur, umfassend wenigstens einen ersten und einen zweiten Chip nach einem der Ansprüche 1 bis 9, **dadurch gekennzeichnet, dass** das Fadenelement des ersten Chips und das Fadenelement des zweiten Chips ein einziges Fadenelement bilden, wobei das einzige Fadenelement gleichzeitig die elektrische Verbindung und eine flexible mechanische Verbindung zwischen den beiden Chips sicherstellt

12. Mikrostruktur nach Anspruch 11, **dadurch gekennzeichnet, dass** das einzige Fadenelement in die Ausnehmungen geklebt ist.

13. Mikrostruktur nach Anspruch 11, **dadurch gekennzeichnet, dass** das einzige Fadenelement in die Ausnehmungen geschweißt ist.

## Claims

1. A microelectronic chip (1) comprising an electrically conductive wire element (10, 11), two parallel front and rear main faces (4, 5), side faces (6, 7) and a recess forming a housing for the electrically conductive wire element (10, 11), the recess being a groove situated on one of the main or side faces, the groove having an axis parallel to the main faces for fixing by embedding the electrically conductive wire element (10, 11) in said groove, the chip having at least one electrical connection element for connecting a microelectronic component integrated in the chip with the wire element, the electrical connection element being, in the case of a groove situated on a side face, made at least partially with a conductive electrical layer coating at least partially said groove; chip **characterized in that** the embedment of the electrically conductive wire element (10, 11) in said groove is made along the longitudinal axis of said groove, said electrically conductive wire element (10, 11) constituting a flexible mechanical support for said chip.

2. The chip according to claim 1, **characterized in that** an electrically conducting layer (12, 13, 24, 25) at least partially coats the recess (8, 9, 20, 21).

3. The chip according to one of claims 1 and 2, **characterized in that** said groove is situated on at least one side face (6, 7).

4. The chip according to one of claims 1 and 2, **characterized in that** said groove is situated on at least one main face (4, 5).

5. The chip according to one of claims 1 to 4, **characterized in that** said groove (8, 9) comprises a concave, square or circular cross section.

6. The chip according to one of claims 1 to 5, **characterized in that** said groove (20, 21) comprises a V-shaped or truncated V-shaped cross section.

7. The chip according to claim 3, **characterized in that** it comprises a first and second elemental chip (16a, 16b) each comprising a small base (17a, 17b) and a large base (18a, 18b) parallel to one another connected by at least one inclined flat side face (19a, 19b) forming an acute angle with the large base (18a, 18b), the first and second elemental chips (16a, 16b) being secured to one another by their small bases (17a, 17b) so that their inclined flat side faces (19a, 19b) constitute said V-shaped or truncated V-shaped groove (20, 21).

8. The chip according to claim 7, **characterized in that** the small base (17a, 17b) of the first and second elemental chips (16a, 16b) comprises an additional groove (34a, 34b) parallel to the V-shaped groove (20, 21), the additional grooves (34a, 34b) of the first and second elemental chips (16a, 16b) being superposed to form an additional housing for a wire element (35).

9. The chip according to claim 4, **characterized in that** the microelectronic component is integrated on the front main face, and **in that** said groove being situated on the rear main face, said at least one electrical connection element is an electrical contact passing through the chip from the front face up to said recess.

10. A fabrication method of a microelectronic chip (1) according to claim 3, **characterized in that** it comprises:
• simultaneous fabrication, on one and the same wafer (27, 33), of a plurality of elemental chips (16a, 16b) separated by V-shaped grooves (28) each comprising two convergent walls (29a, 29b),
• deposition of an electrically conducting material forming, in each elemental chip (16a, 16b), at least one contact (31, 32) arranged between a microelectronic component (23a, 23b) integrated in said elemental chip (16a, 16b) and a wall (29a, 29b) of an adjacent groove (28),
• assembly of two wafers (27, 33) by their faces comprising the grooves (28) so that the grooves (28) are superposed,
• cutting of the assembled wafers (27, 33) at the level of the grooves (28).

11. A microstructure comprising at least a first and a second chips according to any one of claims 1 to 9, **characterized in that** the wire element of the first chip and the wire element of the second chip constitute a single wire element, the single wire element ensuring simultaneously both an electrical connection and a flexible mechanical connection between the two chips.

12. The microstructure according to claim 11, **characterized in that** the wire element is glued in the recesses.

13. The microstructure according to claim 11, **characterized in that** the wire element is soldered in the recesses.
